Europäisches Patentamt

European Patent Office

Office européen des brevets

(11) Veröffentlichungsnummer : **0 048 838**
**B1**

# (12) EUROPÄISCHE PATENTSCHRIFT

(45) Veröffentlichungstag der Patentschrift :
13.03.85

(21) Anmeldenummer : 81106914.5

(22) Anmeldetag : 03.09.81

(51) Int. Cl.⁴ : **H 03 F   3/343**, H 03 K 19/08

(54) Schaltungsanordnung zur belastungsproportionalen Einstellung des Ansteuerstroms eines in Emitterschaltung betriebenen Eintakt-Endstufentransistors eines Transistorverstärkers.

(30) Priorität : 29.09.80 DE 3036736

(43) Veröffentlichungstag der Anmeldung :
07.04.82 Patentblatt 82/14

(45) Bekanntmachung des Hinweises auf die Patenterteilung : 13.03.85 Patentblatt 85/11

(84) Benannte Vertragsstaaten :
DE FR GB IT

(56) Entgegenhaltungen :
DE-A- 2 508 363
US-A- 3 531 660
US-A- 3 577 167
US-A- 4 187 472
Patents Abstracts of Japan Band 3, Nr. 146, 4.
Dezember 1979 Seite 49E156
Siemens Sonderdruck "TAA 861- ein wirtschaftlicher
und vielseitiger Operationsverstärker"

(73) Patentinhaber : Siemens Aktiengesellschaft
Berlin und München Wittelsbacherplatz 2
D-8000 München 2 (DE)

(72) Erfinder : Gehring, Gerhard, Dipl.-Ing.
Geschwister-Scholl-Strasse 7
D-8025 Unterhaching (DE)

## Beschreibung

Die vorliegende Erfindung betrifft eine Schaltungsanordnung zur belastungsproportionalen Einstellung des Ansteuerstroms eines in Emitterschaltung betriebenen Eintakt-Endstufentransistors eines Transistorverstärkers für eine variable Last des Endstufentransistors, wobei dem Endstufentransistor der Ansteuerstrom über einen Ansteuerzweig zugeführt wird.

Bei Eintakt-Ausgangsstufen bzw. Endstufen in Emitterschaltung muß für den maximal zu erwartenden Laststrom der entsprechende Ansteuerstrom zur Verfügung gestellt werden können.

Ist mit sehr hohen Lastströmen zu rechnen, so kann der Ansteuerstrom bei niedrigen Stromverstärkungen im Verhältnis zur Gesamtstromaufnahme sehr hoch sein und beispielsweise im Bereich von 50 % und unter Umständen auch 75 % des Gesamtstroms und mehr liegen. Dies ist insbesondere bei integrierten Standardschaltungen, die ohne äußere Eingriffe unverändert bei verschiedenen Lastströmen verwendet werden sollen, sehr störend, weil die Dimensionierung zwar für die höchsten Lastströme ausgelegt sein muß, aber dieselbe Schaltung auch bei Anwendungen mit sehr niedrigen Lastströmen eingesetzt werden soll, bei denen die verfügbaren Versorgungsströme meist ebenfalls nur sehr klein sind.

Bisher wurde in solchen Fällen meist eine Darlington-Endstufe verwendet, wie dies aus einer druckschriftlichen Veröffentlichung der Anmelderin vom 08.10.1970 mit dem Titel « TAA 861 — ein wirtschaftlicher und vielseitiger Operationsverstärker » bekanntgeworden ist. Dabei gelten die vorgenannten Gesichtspunkte hinsichtlich des Ansteuerstroms sinngemäß ebenso. Dieser Strom ist dann jedoch um etwa zwei Zehnerpotenzen niedriger und gegen die Ströme der übrigen Stufen vernachlässigbar.

Als Nachteil ergibt sich gegenüber der einfachen Emitterschaltung eines Eintakt-Endstufentransistors eine um eine Basis-Emitterspannung höhere Sättigungsspannung von etwa 0,9 V. Damit sind aber beispielsweise TTL-Schaltungen nicht mehr sicher ansteuerbar, weil dazu Spannungen erforderlich sind, welche kleiner als 0,4 V sind.

Mit einer derartigen Darlington-Endstufe ist daher das Problem der Stromaufnahme nur um den Preis einer kleineren Flexibilität gelöst. (TTL-Schaltungen sind nicht ansteuerbar.).

Es ist zwar bereits aus der US-A-4 187 472 bekannt, in Verstärkerschaltungen eine Rückkopplung durch einen Rückkoppeltransistor vorzunehmen, dessen Basis und Emitter an die Basis bzw. den Emitter eines in Emitterschaltung betriebenen Ausgangstransistors angekoppelt sind, wobei der Rückkoppeltransistor einen dem Ausgangsstrom direkt proportionalen Kollektorstrom führt, der auf den Eingang eines den Ausgangstransistor treibenden Verstärkers rückgeführt wird. Insbesondere in Gegentaktverstärkern für induktive Lasten liegt bei den Basis-Emitterstrecken von Transistorverstärkerstufen einer Gegentakt-Endstufe jeweils die Basis-Emitterstrecke eines Rückkoppeltransistors parallel. In den Kollektorkreisen der Rückkoppeltransistoren liegt ein Stromspiegel, von dem ein Gegenkopplungssignal auf einen die Endstufe treibenden Verstärker geführt wird. Daraus ergibt sich, daß die Kollektorströme der Transistoren der Gegentaktstufe den Kollektorströmen der Rückkoppeltransistoren direkt proportional sind. Diese Maßnahme dient jedoch der Regelung der Gesamtverstärkung, der Verzerrungsreduzierung sowie der Regelung der Ruheströme der Ausgangstransistoren, nicht aber einer Einstellung der Ansteuerströme der Endstufentransistoren für sich ändernde Lasten.

Der vorliegenden Erfindung liegt die Aufgabe zugrunde, eine Möglichkeit zur belastungsproportionalen Ansteuerung einer in Emitterschaltung betriebenen Eintakt-Endstufe anzugeben, bei der das vorgenannte Restspannungs-Problem nicht auftritt.

Diese Aufgabe wird bei einer Schaltungsanordnung der eingangs genannten Art erfindungsgemäß durch folgende Merkmale gelöst :

Eine von der Basis-Emitterspannung des Endstufentransistors angesteuerte, mit ihrem Basis-Emitterkreis dem Basis-Emitterkreis des Endstufentransistors parallel liegende Abtast-Transistorstufe und durch einen Stromspiegel, über den der Strom im Ausgangskreis der Abtast-Transistorstufe in den Kollektorkreis eines als Ansteuer-Transistor für den Endstufentransistor dienenden, vom Ansteuerzweig angesteuerten Transistors einspeisbar ist.

Die vorstehend definierte erfindungsgemäße Lösung geht von der Erkenntnis aus, daß die Basis-Emitterspannung des Endstufentransistors bzw. Ausgangstransistors eine Funktion des Ausgangsstromes ist und mit diesem logarithmisch ansteigt. An der Basis-Emitterstrecke des Endstufentransistors bzw. Ausgangstransistors steht daher eine Information über den tatsächlich fließenden Ausgangsstrom zur Verfügung, ohne daß dabei in den Lastkreis eingegriffen und ohne daß die Impedanzverhältnisse im Lastkreis durch Emitterwiderstände verändert werden müssen.

Spezielle Ausgestaltungen des Erfindungsgedankens sind in Unteransprüchen gekennzeichnet.

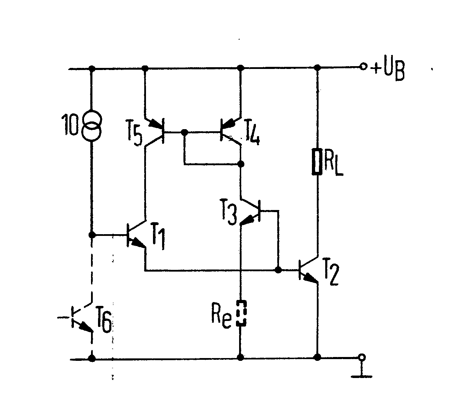

Die Erfindung wird im folgenden anhand eines in der einzigen Figur der Zeichnung in Form eines Schaltbildes dargestellten Ausführungsbeispiels näher erläutert.

Im Schaltbild nach der Figur der Zeichnung bildet ein in Emitterschaltung betriebener Transistor $T_2$ eine Eintakt-Endstufe eines Transistorverstärkers. Im Kollektorzweig dieses Transistors $T_2$ liegt eine Last an einer Batteriespannung $+ U_B$. Die Last ist im vorliegenden Ausführungsbeispiel der Einfachheit halber als Lastwiderstand $R_L$ dargestellt. In der Praxis kann diese Last durch den Eingangswiderstand einer weiteren Schaltung, beispielsweise einer integrierten TTL-Schaltung gebildet werden.

Die Basis-Emitterspannung des Endstufentransistors $T_2$ wird über einen Abtast-Transistor $T_3$ erfaßt. In integrierten Schaltungen gestaltet sich diese Erfassung bzw. Auswertung der Basis-Emitterspannung des Ausgangstransistors $T_2$ besonders einfach. Wird der Abtast-Transistor $T_3$ gemäß einem besonderen Merkmal der Erfindung im gleichen Halbleiterkristall in unmittelbarer Nähe des Ausgangstransistors $T_2$ angeordnet, so liefert er unter der Voraussetzung gleicher Geometrie bei gleicher Basis-Emitterspannung denselben Strom wie der Ausgangstransistor $T_2$. Bei kleineren Abmessungen des Abtast-Transistors $T_3$ in Bezug auf den Ausgangstransistor $T_2$ ist der Strom um einen definierten Faktor kleiner.

Der im Abtast-Transistor $T_3$ fließende Strom kann nun als verfügbarer Ansteuerstrom über eine Koppelschaltung zurückgeführt werden. Diese Koppelschaltung wird im vorliegenden Ausführungsbeispiel durch einen durch Transistoren $T_4$ und $T_5$ gebildeten Stromspiegel an der Versorgungsspannung $+U_B$ gespiegelt. Dieser Stromspiegel besitzt eine definierte Stromverstärkung von insbesondere etwa 1.

Über den Stromspiegel $T_4$, $T_5$ wird der Kollektor eines Ansteuer-Transistors $T_1$ gespeist, welcher an seiner Basis aus einer Stromquelle 10 und gegebenenfalls von einem von (nicht dargestellten) Vorstufen des Transistorverstärkers gesteuerten transistor $T_6$ angesteuert wird.

Um anzudeuten, daß der Steuerkreis gegebenenfalls komplexere Schaltungen umfassen kann, ist der Transistor $T_6$ gestrichelt dargestellt.

In praktischer Ausführung der vorstehend beschriebenen und dargestellten Schaltungsanordnung kann gemäß einer Weiterbildung der Erfindung als Ausgleich für die Bahnwiderstände des Endstufentransistors $T_2$, welche eine etwas erhöhte Basis-Emitterspannung bewirken, noch ein kleiner Emitterwiderstand $R_e$ vorgesehen werden der, da nicht unbedingt erforderlich, gestrichelt dargestellt ist.

Für einen bestimmten, aktuell vorliegenden Wert des Lastwiderstandes $R_L$ fließt ein bestimmter Laststrom über den Kreis des Ausgangstransistors $T_2$. Für diesen tatsächlichen Laststrom fließt im Kreis der Stromquelle 10 ein Ansteuerstrom, welcher dem Quotienten aus dem tatsächlich fließenden Laststrom und dem Produkt aus den Stromverstärkungen der Transistoren $T_1$ und $T_2$ proportional ist. Als Restspannung an der Kollektor-Emitterstrecke des Ausgangstransistors $T_2$ ergibt sich lediglich die Sättigungsspannung dieses Transistors. Dies hat gegenüber einer eingangs erläuterten Darlington-Konfiguration aus dem Lasttransistor $T_2$ und einem weiteren vorgeschalteten Transistor den Vorteil, daß die Restspannung kleiner ist, weil bei einer Darlington-Konfiguration die Restspannung gleich der Summe aus der Basis-Emitterspannung des Endstufentransistors und der Sättigungsspannung des Eingangstransistors der Darlington-Stufe ist.

## Ansprüche

1. Schaltungsanordnung zur belastungsproportionalen Einstellung des Ansteuerstroms eines in Emitterschaltung betriebenen Eintakt-Endstufentransistors ($T_2$) eines Transistorverstärkers für eine variable Last ($R_L$) des Endstufentransistors ($T_2$), wobei dem Endstufentransistor ($T_2$) der Ansteuerstrom über einen Ansteuerzweig (10, $T_6$) zugeführt wird, gekennzeichnet durch eine von der Basis-Emitterspannung des Endstufentransistors ($T_2$) angesteuerte, mit ihrem Basis-Emitterkreis dem Basis-Emitterkreis des Endstufentransistors ($T_2$) parallel liegende Abtast-Transistorstufe ($T_3$) und durch einen Stromspiegel ($T_4$, $T_5$), über den der Strom im Ausgangskreis der Abtast-Transistorstufe ($T_3$) in den Kollektorkreis eines als Ansteuer-Transistor ($T_1$) für den Endstufentransistor ($T_2$) dienenden, vom Ansteuerzweig (10, $T_6$) angesteuerten Transistors ($T_1$) einspeisbar ist.

2. Schaltungsanordnung nach Anspruch 1, dadurch gekennzeichnet, daß die Abtast-Transistorstufe ($T_3$) durch einen in Emitterschaltung betriebenen, über seinen Kollektor in Serie zum Stromspiegel ($T_4$, $T_5$) liegenden Transistor ($T_3$) gebildet ist.

3. Schaltungsanordnung nach Anspruch 1 und 2, dadurch gekennzeichnet, daß bei Ausbildung als integrierter Schaltkreis der Endstufentransistor ($T_2$) und der Abtast-Transistor ($T_3$) unmittelbar benachbart zueinander in einem den integrierten Schaltkreis enthaltenden Halbleiterkristall angeordnet sind.

4. Schaltungsanordnung nach einem der Ansprüche 1 bis 3, dadurch gekennzeichnet, daß im Emitterzweig des Abtast-Transistors ($T_3$) ein Widerstand ($R_e$) liegt.

## Claims

1. Circuit arrangement for the load-proportional regulation of the control current in a common emitter single-ended output stage transistor ($T_2$) of a transistor amplifier for a variable load ($R_L$) of the output stage transistor ($T_2$), where the output stage transistor ($T_2$) is supplied with the drive current via a drive arm (10 and 6) characterised by a sampling transistor stage ($T_3$) which is driven by the base-emitter voltage of the output stage transistor ($T_2$) and is connected with its base-emitter circuit in parallel to the base-emitter circuit of the output stage transistor ($T_2$), and further characterised by a current mirror ($T_4$, $T_5$) via which the current in the output circuit of the sampling transistor stage ($T_3$) can be fed into the collector circuit of a transistor ($T_1$) which serves as drive transistor ($T_1$) for the output stage

transistor ($T_2$) and is driven by the drive arm (10 and 6).

2. A circuit arrangement as claimed in Claim 1, characterised in that the sampling transistor stage ($T_3$) is formed by a transistor ($T_3$) operated in a common emitter stage and whose collector is arranged in series with the current mirror ($T_4$, $T_5$).

3. A circuit arrangement as claimed in Claim 1 and 2, characterised in that the circuit is integrated in a semiconductor crystal and the output stage transistor ($T_2$) and the sampling transistor ($T_3$) are arranged directly adjacent to one another.

4. A circuit arrangement as claimed in one of Claims 1 to 3, characterised in that a resistor ($R_e$) is arranged in the emitter arm of the sampling transistor ($T_3$).

**Revendications**

1. Circuit pour régler, proportionnellement à la charge, le courant de commande d'un transistor ($T_2$), en émetteur commun et à simple alternance, de l'étage de sortie d'un amplificateur à transistors pour une charge variable ($R_L$) du transistor ($T_2$) de l'étage de sortie, le courant de commande étant appliqué au transistor ($T_2$) de l'étage de sortie par l'intermédiaire d'une branche de commande (10, $T_6$), caractérisé par un étage de détection à transistor ($T_3$) commandé par la tension base-émetteur du transistor ($T_2$) de l'étage de sortie et monté en parallèle par son circuit base-émetteur, sur le circuit base-émetteur et par un dispositif dit à courants en rapport géométrique ($T_4$, $T_5$), par l'intermédiaire duquel le courant qui passe dans le circuit de sortie de l'étage de détection à transistor ($T_3$), est susceptible d'être amené dans le circuit de collecteur d'un transistor ($T_1$) servant de transistor d'attaque ($T_1$) pour le transistor de l'étage final ($T_2$) et commandé par la branche de commande (10, $T_6$).

2. Circuit selon la revendication 1, caractérisé par le fait que l'étage de détection à transistor ($T_3$) est formé par un transistor ($T_3$) en montage à émetteur commun et situé, par l'intermédiaire de son collecteur, en série avec le dispositif à courants en rapport géométrique ($T_4$, $T_5$).

3. Circuit selon les revendications 1 et 2, caractérisé par le fait que dans le cas d'une réalisation sous la forme d'un circuit de commutation intégré, le transistor ($T_2$) de l'étage de sortie et le transistor ($T_3$) de détection, sont disposés dans le voisinage immédiat l'un de l'autre dans un cristal semi-conducteur contenant le circuit de commutation.

4. Circuit selon l'une des revendications 1 à 3, caractérisé par le fait qu'une résistance ($R_e$) est montée dans la voie de l'émetteur du transistor de détection ($T_3$).